(19) Europäisches Patentamt
European Patent Office
Office européen des brevets

(11) **EP 4 616 215 B1**

(12) **EUROPÄISCHE PATENTSCHRIFT**

(45) Veröffentlichungstag und Bekanntmachung des Hinweises auf die Patenterteilung:
**22.07.2026 Patentblatt 2026/30**

(21) Anmeldenummer: **23798892.8**

(22) Anmeldetag: **25.10.2023**

(51) Internationale Patentklassifikation (IPC):
**G01R 33/26** (2006.01)  **G01R 33/32** (2006.01)

(52) Gemeinsame Patentklassifikation (CPC):
**G01R 33/26; G01R 33/323**

(86) Internationale Anmeldenummer:
**PCT/EP2023/079743**

(87) Internationale Veröffentlichungsnummer:
**WO 2024/099770 (16.05.2024 Gazette 2024/20)**

(54) **MAGNETOMETEREINHEIT MIT MAGNETFELDMODULATION ZUR RICHTUNGSSENSITIVEN MESSUNG EINES MAGNETFELDS UND GRADIOMETEREINHEIT MIT MAGNETOMETEREINHEIT**

MAGNETOMETER UNIT WITH MAGNETIC FIELD MODULATION FOR DIRECTION-SENSITIVE MEASUREMENT OF A MAGNETIC FIELD, AND GRADIOMETER UNIT WITH MAGNETOMETER UNIT

UNITÉ DE MAGNÉTOMÈTRE AVEC MODULATION DE CHAMP MAGNÉTIQUE POUR MESURE SENSIBLE À LA DIRECTION D'UN CHAMP MAGNÉTIQUE, ET UNITÉ DE GRADIOMÈTRE AVEC UNITÉ DE MAGNÉTOMÈTRE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **09.11.2022 DE 102022211859**

(43) Veröffentlichungstag der Anmeldung:
**17.09.2025 Patentblatt 2025/38**

(73) Patentinhaber: **Robert Bosch GmbH
70442 Stuttgart (DE)**

(72) Erfinder:
• **BRENNEIS, Andreas
71272 Renningen (DE)**
• **WEGGLER, Timo
89134 Blaustein (DE)**
• **WEHRSE, Eckhard
70563 Stuttgart (DE)**

(56) Entgegenhaltungen:
• **ACOSTA V M ET AL: "Broadband magnetometry by infrared-absorption detection of nitrogen-vacancy ensembles in diamond", ARXIV.ORG, CORNELL UNIVERSITY LIBRARY, 201 OLIN LIBRARY CORNELL UNIVERSITY ITHACA, NY 14853, 24 September 2010 (2010-09-24), XP080450740, DOI: 10.1063/1.3507884**
• **"High Sensitivity Magnetometers", 2017, SPRINGER, Switzerland, ISBN: 978-3-319-34070-8, article KASPER JENSEN ET AL: "Magnetometry with Nitrogen-Vacancy Centers in Diamond", pages: 553 - 576, XP055645444, DOI: 10.1007/ 978-3-319-34070-8_18**
• **S. M. BLAKLEY ET AL: "Fiber-optic vectorial magnetic-field gradiometry by a spatiotemporal differential optical detection of magnetic resonance in nitrogen-vacancy centers in diamond", OPTICS LETTERS, vol. 41, no. 9, 27 April 2016 (2016-04-27), US, pages 2057, XP055680838, ISSN: 0146-9592, DOI: 10.1364/ OL.41.002057**

- **HAITHAM A R EL-ELLA ET AL: "Optimised frequency modulation for continuous-wave optical magnetic resonance sensing using nitrogen-vacancy ensembles", ARXIV.ORG, CORNELL UNIVERSITY LIBRARY, 201 OLIN LIBRARY CORNELL UNIVERSITY ITHACA, NY 14853, 4 July 2017 (2017-07-04), XP080774204, DOI: 10.1364/OE.25.014809**

## Beschreibung

Die vorliegende Erfindung betrifft eine Magnetometereinheit zur Messung eines Magnetfelds sowie Gradiometereinheit mit wenigstens zwei solcher Magnetometereinheiten.

Hintergrund der Erfindung

Um sehr kleine Magnetfeldstärken zu messen, eignen sich als Sensoren insbesondere optisch gepumpte oder auf NV-Zentren in Diamant basierende Quantensensoren. In der DE 10 2022 204 526.2 wird ein Magnetometer beschrieben, das optisch gepumpte und optisch detektierte magnetische Resonanzen (optically detected magnetic resonance, ODMR) nutzt. Dabei wird ausgenutzt, dass unter Einfluss eines äußeren Magnetfelds die Energieniveaus bestimmter Spinzustände ungepaarter Elektronen aufspalten, der sogenannte Zeeman-Effekt. Durch die Aufspaltung der Energieniveaus ergeben sich veränderte Übergänge bei der Relaxation aus angeregten Zuständen, die dann beispielsweise durch optische Anregung und frequenzabhängige Detektion der resultierenden Fluoreszenzstrahlung oder durch Beobachtung optischer Eigenschaften wie der Absorption von Licht gemessen werden können. Aus den gemessenen optischen Parametern kann dann wiederum auf die Magnetfeldstärke geschlossen werden.

Die Veröffentlichung V. M. Acosta et al. "Broadband magnetometry by infraredabsorption detection of nitrogen-vacancy ensembles in diamond" in Appl. Phys. Lett. 97, 174104 (2010) offenbart en Magnetometer auf Basis von Stickstoff-Fehlstellen-Ensembles (NV-Zentren) in Diamant. Anstatt der üblichen Fluoreszenz-Detektion wird eine Infrarot-Absorption bei 1042 nm zur Auslesung der Spinzustände genutzt. Dies erhöht den Kontrast und die Detektionseffizienz, was zu einer verbesserten magnetischen Empfindlichkeit führt. Mittels einer phasen-sensitiver Detektion wird das Signal-zu Rauschen-Verhältnis verbessert, was die Messung von Magnetfeldern mit hoher Präzision ermöglicht.

Offenbarung der Erfindung

Erfindungsgemäß werden eine Magnetometereinheit zur Messung eines Magnetfelds mit den Merkmalen des Patentanspruchs 1 und eine Gradiometereinheit mit wenigstens zwei solchen Magnetometereinheiten vorgeschlagen. Vorteilhafte Ausgestaltungen sind Gegenstand der Unteransprüche sowie der nachfolgenden Beschreibung.

Im Einzelnen wird eine Magnetometereinheit zur Messung eines Magnetfelds vorgeschlagen mit einem Sensormedium, das dem zu messenden Magnetfeld ausgesetzt ist, einer Anregungslichtquelle zum Einstrahlen von Licht in das Sensormedium, einer Mikrowellenquelle zum Erzeugen eines elektromagnetischen Felds in dem Sensormedium und einer Einrichtung zum Erzeugen eines Bias-Magnetfelds im Bereich des Sensormediums. Die Magnetometereinheit ist dazu eingerichtet, eine magnetische Feldstärke und Feldrichtung des zu messenden Magnetfelds durch Auslesen einer von der magnetischen Feldstärke und Feldrichtung abhängigen Spinresonanz in dem Sensormedium zu erfassen. Zum Auslesen kann beispielsweise ein Photodetektor zum Erfassen von Fluoreszenzlicht aus dem Sensormedium oder ein Photostromdetektor dienen.

Erfindungsgemäss weist das Sensormedium einen Diamantkristall oder einen Abschnitt eines Diamantkristalls mit Stickstoff-Fehlstellen-Zentren (NV, nitrogen vacancy) auf. Diamant-NV-Magnetometer beruhen auf dem Auslesen der Magnetresonanzen von speziellen Defektzentren in Diamant, insbesondere von Stickstoff-Fehlstellen, die als Verunreinigungen des Kohlenstoffgitters von Diamant auftreten und auch gezielt eingebracht werden können. Wird das NV-Zentrum im Grundzustand optisch angeregt, indem z.B. ein Pumplaserstrahl mit geeigneter Wellenlänge (in diesem Fall im grünen Wellenlängenbereich, z.B. bei 532nm für eine off-resonance-Anregung) eingestrahlt wird, werden die Elektronen vom Triplett-Grundzustand in den angeregten Triplett-Zustand gehoben und relaxieren unter Emission von Fluoreszenzlicht im roten Wellenlängenbereich bei 650 - 800 nm (637nm = zero phonon line). Da die Wahrscheinlichkeit für nicht spinerhaltende Übergänge aus dem Spinzustand mit der Spinquantenzahl $m_s = \pm 1$ größer ist, sorgt ein fortlaufendes Anregungspumpen dafür, dass die NV-Zentren größtenteils im Spinzustand $m_s = 0$ hyperpolarisiert werden.

Zwischen den $m_s = 0$ und $m_s = \pm 1$ Spinzuständen im Grundzustand besteht eine Energiedifferenz, die in diesem Fall bei etwa 2,87 GHz liegt. Strahlt man also neben der optischen Anregung noch Mikrowellenstrahlung in den Diamanten ein, kommt es bei dieser Resonanzfrequenz von 2,87 GHz zu einem Einbruch der roten Fluoreszenz, da die spinpolarisierten Elektronen durch das Mikrowellenfeld vom $m_s = 0$ in den $m_s = \pm 1$-Grundzustand gehoben werden und von dort durch das Pumplicht in den $m_s = \pm 1$ angeregten Zustand angeregt werden. Von dort treten jedoch vor allem nichtstrahlende Übergänge und schwach infrarote Fluoreszenzübergänge über den Singulett-Zustand auf, während die Fluoreszenz im roten Bereich wegfällt.

Wenn nun ein externes (zu messendes) Magnetfeld vorhanden ist, kommt es durch den sogenannten Zeeman-Effekt zur Aufspaltung der ansonsten gleichenergetischen $m_s = \pm 1$ Triplett-Niveaus in energetisch äquidistante Zeeman-Niveaus. Bei Auftragung der Fluoreszenz gegen ein Frequenzspektrum der Mikrowellenanregung zeigen sich dann zwei Dips im Fluoreszenzspektrum, deren Frequenzabstand proportional zur magnetischen Feldstärke des externen Magnetfelds ist. Die Magnetfeldsensitivität wird dabei vor allem durch die minimal auflösbare Frequenzverschiebung definiert und kann bis 1 pT/√Hz oder weniger erreichen. Da das NV-Zentrum im einkristallinen Diamanten vier Möglichkeiten besitzt, sich im Kristallgitter anzuordnen, kommt es bei Anwesenheit eines zusätzlichen Bias-Magnetfelds dazu, dass die im Kristall vorhandenen NV-Zentren je nach Lage im Kristall unterschiedlich stark auf das äußere Magnetfeld reagieren. Dadurch können im Idealfall vier Paare von Fluoreszenz-Minima im Spektrum auftauchen, aus deren Form und Lage zueinander sowohl die Magnetfeldstärke als Betrag als auch die Richtung des externen Magnetfelds eindeutig bestimmbar sind.

Um Magnetfeldmessungen zu ermöglichen, weist die Magnetometereinheit daher die Einrichtung zum Erzeugen des Bias-Magnetfelds im Bereich des Sensormediums auf. Es kann sich dabei um eine Helmholtz-Spulenanordnung handeln, wobei mindestens das Sensormedium innerhalb der Helmholtz-Spulenanordnung angeordnet ist. Es kann sich ebenso um andere Einrichtungen handeln wie z.B. eine einfache Spule, eine langgezogene Spule, Permanentmagnetlösungen wie z.B. in einem Hallbacharray usw. Damit zusätzlich vektorielle (richtungsabhängige) Magnetinformationen bestimmt werden können, ist hierbei eine definierte Richtung des Bias-Magnetfeldes nötig.

Es hat sich gezeigt, dass es bei Anlegen eines konstanten Bias-Magnetfelds in gewissen Situationen zu einer Nicht-Eindeutigkeit der Richtungsbestimmung kommen kann, d.h. es kann nicht zwischen Richtungen entlang des oder entgegen dem angelegten statischen Bias-Magnetfeld(s) unterschieden werden. Daher wird nun vorgeschlagen, dass das Bias-Magnetfeld einen konstanten und einen zeitlich veränderlichen Anteil aufweist. Indem nun dem statischen Bias-Magnetfeld ein variabler Anteil hinzugefügt wird, wird die Unterscheidung der Richtung des zu messenden Magnetfeldvektors möglich. Damit kann die Bestimmung der Richtung eines Magnetfelds garantiert werden.

Zumindest der zeitlich veränderliche Anteil kann sehr einfach durch eine Variation eines Stroms durch eine oder mehrere Spulen erzeugt werden, z.B. mittels eines modulierbaren Stromtreibers.

In einer Ausgestaltung beträgt eine Amplitude des zeitlich veränderlichen Anteils weniger als 50%, insbesondere höchstens 10% oder höchstens 20% oder höchstens 30% einer Amplitude des konstanten Anteils. Somit wird das Bias-Magnetfeld insbesondere nicht umgepolt, und weiter insbesondere hauptsächlich durch den statischen Anteil bestimmt.

In einer Ausgestaltung folgt der zeitlich veränderliche Anteil einer periodischen Funktion, insbesondere Sinusfunktion. Dies erleichtert die Auswertung, insbesondere wenn zusätzlich eine Grundfrequenz des zeitlich veränderlichen Anteils mindestens 10 Hz und/oder höchstens 10 kHz beträgt.

Wenn eine Gradiometerverschaltung von wenigstens zwei Magnetometereinheiten verwendet wird, hat immer eine Magnetometereinheit einen größeren Abstand zur Magnetfeldquelle als eine andere Magnetometereinheit. Durch die Gradiometerverschaltung, d.h.

im Wesentlichen (vektorielle) Subtraktion des Gemessenen, entspricht der Magnetfeldgradient näherungsweise dem Feld, das von der schwachen Quelle ausgeht, während wesentlich stärkere Hintergrundfelder (die in beiden Magnetometereinheiten im Wesentlichen gleich sind) eliminiert werden.

Damit entfällt die Notwendigkeit einer magnetischen Abschirmung, so dass die Magnetfeldmessung in Alltagsumgebungen möglich wird. Die Erfindung eignet sich entsprechend insbesondere zur nichtabgeschirmten Messung schwacher Magnetfelder. Technische Details zu Gradiometerlösungen, die auch im Rahmen der vorliegenden Erfindung angewendet werden können, sind in der DE 102022201690.4 offenbart.

In einer Ausgestaltung kann das Sensormedium der Magnetometereinheiten der Gradiometereinheit jeweils einen Abschnitt desselben Diamantkristalls umfassen. In dieser Bauweise ist, neben der Kompaktheit, auch sichergestellt, dass die beiden als Sensormedium genutzten Abschnitte im Wesentlichen gleiche Eigenschaften aufweisen und damit auch die gleichen optischen Eigenschaften bei der Auslesung der Spinresonanz zeigen, so dass keine Fehlerquellen bei der Differenzbildung des Gradiometers entstehen. In einer Ausgestaltung werden für die Magnetometereinheiten der Gradiometereinheit dieselbe Anregungslichtquelle und/oder dieselbe Mikrowellenquelle verwendet. Auf diese Weise werden Schwankungen und Rauschanteile aus diesen Elementen automatisch durch die Differenzsignalbildung eliminiert (common noise rejection).

Weitere Vorteile und Ausgestaltungen der Erfindung ergeben sich aus der Beschreibung und der beiliegenden Zeichnung.

Die Erfindung ist anhand von Ausführungsbeispielen in der Zeichnung schematisch dargestellt und wird im Folgenden unter Bezugnahme auf die Zeichnung beschrieben.

Kurze Beschreibung der Zeichnungen

Figur 1 zeigt in einer schematischen Blockansicht die wesentlichen Komponenten eines NV-Zentren-Magnetometers, wie es im Rahmen der Erfindung Anwendung finden kann.

Figur 2 zeigt schematisch zwei Magnetfelder, die bei nicht-erfindungsgemäßer Verwendung eines statischen Bias-Magnetfelds nicht unterschieden werden können.

Figur 3 zeigt den Verlauf von Messsignalen für entgegengesetzt ausgerichtete Magnetfelder bei Messung gemäß einer Ausführungsform der Erfindung.

Ausführungsform(en) der Erfindung

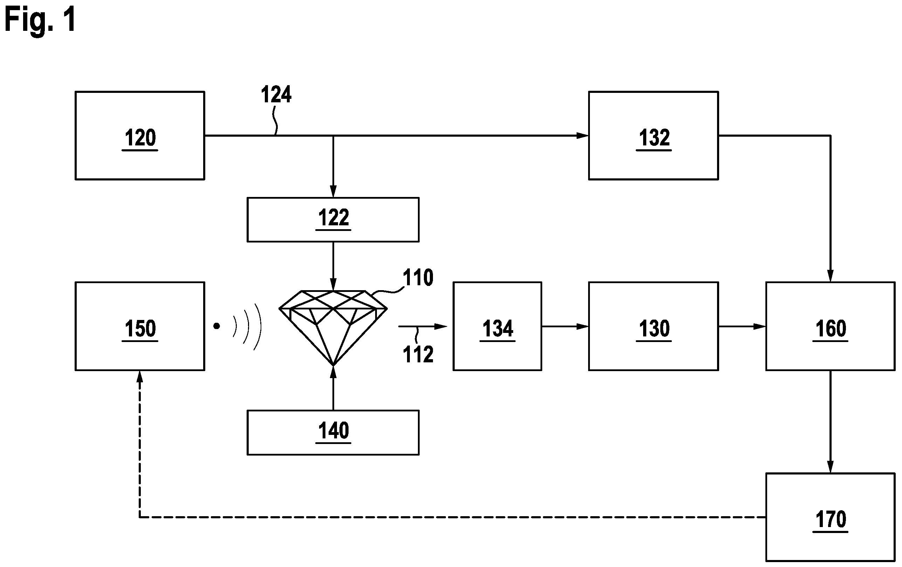

Figur 1 zeigt schematisch die wesentlichen Komponenten eines NV-Zentren-Magnetometers gemäß einer Ausgestaltung. Dabei ist zunächst ein Diamant 110 mit Stickstoff-Fehlstellen (NV) als Sensormedium vorhanden. Die optische Anregung der NV-Zentren kann durch eine geeignete Lichtquelle 120 wie etwa einen Pumplaser erreicht werden. Hier eignet sich beispielsweise ein frequenzverdoppelter Nd:YAG-Laser oder Halbleiterlaser im grünen Bereich von etwa 510-532nm, z.B. bei 532nm für eine off-resonance-Anregung. Alternativ können auch LEDs in geeigneten Wellenlängenbereichen genutzt werden. Je nach Anordnung kann das Licht der Lichtquelle 120 über geeignete optische Elemente 122 wie etwa Spiegel, Strahlteiler, fokussierende Optik wie Linsen und gegebenenfalls über faseroptische Elemente in den Diamanten 110 eingestrahlt werden. Außerdem kann das Anregungslicht durch den Laser kontinuierlich oder gepulst eingestrahlt werden, so dass beispielsweise Zeitfenster zur störungsfreien Fluoreszenzlichtmessung freigehalten werden.

Weiter kann das Magnetometer eine Mikrowellenquelle 150 umfassen, die in der Lage ist, ein elektromagnetisches Feld über eine Bandbreite hinweg, die die erwünschte Resonanzfrequenz abdeckt, im Sensormedium zu erzeugen, d.h. im Bereich der NV-Zentren des Diamanten 110. Eine Mikrowellen-Resonatorstruktur kann verwendet werden, um die erzeugten Mikrowellen über das Volumen des Messbereichs im Diamanten homogen zu verteilen. Die Resonatorstruktur bzw. die Mikrowellenquelle 150 ist dabei bevorzugt auf die Frequenz der Elektronenspinresonanzen gestimmt. Um Vektormagnetometrie zu ermöglichen, wird ein zusätzliches Bias-Magnetfeld mittels einer Einrichtung 140 erzeugt. Dadurch wird die Messung intrinsisch vektoriell. Dazu werden verschiedene Raumrichtungen in der Kristallstruktur verwendet. Zur Erzeugung eines solchen Magnetfelds eignet sich beispielsweise eine Helmholtz-Spule, bei der mittels eines Spulenpaars ein im Wesentlichen homogenes Magnetfeld in einem begrenzten Bereich erzeugt werden kann. Es kann sich ebenso um andere Einrichtungen 140 handeln wie z.B. eine einfache Spule, eine langgezogene Spule, Permanentmagnetlösungen wie z.B. in einem Hallbacharray usw.

Das entstehende Fluoreszenzlicht 112 aus dem Diamanten 110 kann wiederum über geeignete optische Elemente 134 wie etwa optische Filter, Strahlteiler, Linsen, und/oder faseroptische Elemente zu einem ersten Photodetektor 130 geleitet werden, der mindestens im Bereich der Fluoreszenzwellenlänge empfindlich ist. Der erste Photodetektor 130 kann auch unmittelbar an dem Diamanten 110 angeordnet sein. Ein zweiter Photodetektor 132 ist so angeordnet, dass er zumindest einen Teil des Anregungslichts der Lichtquelle 120 detektieren kann, welches beispielsweise durch einen Strahlteiler, einen Filter oder ein teildurchlässiges Element ausgekoppelt werden kann. Dieses Detektorsignal 132 des Anregungslichts kann als Referenzsignal verwendet werden, um beispielsweise durch Modulation des Anregungslichts mittels eines Lock-In-Verstärkers Hintergrundsignale zu eliminieren und das interessierende Resonanzsignal herauszustellen. Zusätzlich oder alternativ kann dieses Referenzsignal verwendet werden, um Schwankungen des Anregungslichts zu berücksichtigen. Entsprechende Schaltungen 160 wie ein Vorverstärker, ein logarithmischer Verstärker, ein Lock-In-Verstärker, Signalfilter oder andere sind also vorgesehen, um die Signale des ersten und des zweiten Photodetektors zu erhalten und die Signale auf geeignete Weise für die weitere Auswertung vorzuverarbeiten. Schließlich kann durch eine Signalverarbeitungseinheit 170 das vorverarbeitete Fluoreszenzsignal ausgewertet werden, z.B. mit einem geeigneten Mikrocontroller oder Prozessor, um aus dem Signal die gewünschten Parameter des detektierten Magnetfelds zu erhalten, insbesondere die Magnetfeldstärke und die Richtung des Magnetfelds.

Es versteht sich, dass eine solche Vorrichtung auch weitere, nicht gezeigte Einheiten aufweisen kann, wie Kommunikationseinheiten bzw. Schnittstellen zur Ausgabe der Messergebnisse. Eine solche Vorrichtung kann auch vorteilhaft in ein ASIC oder FPGA integriert sein.

Das NV-Zentren-Magnetometer bietet eine Vielzahl von Vorteilen für die vorliegende Anwendung. Neben der bereits erwähnten sehr hohen Empfindlichkeit kann auch ein hoher Messbereich (> 1 Tesla) abgedeckt werden. Der zugrundeliegende Zeeman-Effekt ist linear vom vorhandenen Magnetfeld abhängig und zeigt außerdem keine Degradation, da die Messung auf quantenmechanischen Zuständen beruht. Außerdem bietet ein NV-Zentren-Magnetometer die Möglichkeit, externe Magnetfelder vektoriell anhand der im Diamantgitter vorhandenen verschiedenen Ausrichtungen zu bestimmen.

Es gibt auch alternative Möglichkeiten, die magnetische Spin-Resonanz in Diamant elektrisch auszulesen. Dabei werden Ladungsträger detektiert, die durch Zwei-Photon-Ionisierung der NV-Zentren in das Leitungsband von Diamant angehoben wurden. Wird ein solches Verfahren zum Auslesen der Resonanzeffekte genutzt, sind die Teile zur Detektion des Fluoreszenzlichts in den vorhergehenden Beispielen nicht erforderlich und werden durch geeignete Photostromdetektoren am Diamant ersetzt. Davon abgesehen kann das Verfahren zur Magnetfeldmessung aber entsprechend übertragen werden und in allen Ausführungsformen mit NV-Zentren-Magnetometern angewendet werden.

Um in einer Alltagsumgebung einsetzbar zu sein, sollen Magnetfelder, die nicht von gewünschten schwachen Quellen stammen, aus der Messung möglichst eliminiert werden, insbesondere das Erdmagnetfeld im Bereich von $10^{-5}$ Tesla (einige Mikrotesla).

Die Eliminierung der Hintergrundmagnetfelder kann durch eine Abschirmung oder durch eine Gradiometeranordnung bei der Magnetfeldmessung gemäß beispielhaften Ausführungsformen erreicht werden. Als Gradiometer werden grundsätzlich Magnetometereinheiten bezeichnet, die in der Lage sind, nicht nur die Feldstärke, sondern auch den Gradienten des Felds zu erfassen. Dazu können mindestens zwei einzelne Magnetometereinheiten verwendet werden, die an räumlich unterschiedlichen Stellen angeordnet sind, und deren Signale miteinander verrechnet werden.

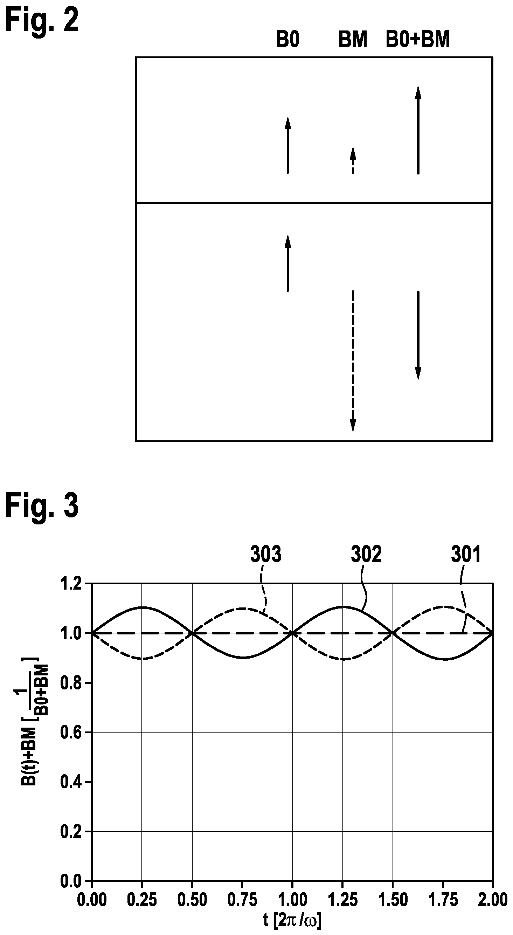

In Figur 2 ist ein Beispiel für zu messende Magnetfelder BM angegeben, die herkömmlicherweise bei Verwendung eines statischen Bias-Magnetfelds B0 nicht unterschieden werden können. Grundsätzlich kann bei einer solchen NV-Magnetometereinheit nämlich nicht zwischen Magnetfeldern parallel und antiparallel zum Bias-Magnetfeld unterschieden werden. Eine solche Unterscheidung kann zwar noch anhand der Magnetfeldstärke getroffen werden, wenn das resultierende Feld B0+BM kleiner als das Bias-Magnetfeld B0 ist (da dann das zu messende Feld notwendigerweise antiparallel sein muss). Ist jedoch das resultierende Feld B0+BM größer als das Bias-Magnetfeld B0, kann nicht zwischen einem "kleinen" (kleiner als B0) parallelen und einem "großen" (größer als B0) antiparallelen zu messenden Feld BM unterschieden werden.

Wenn also das gemessene resultierende Feld B0+BM (rechte Pfeile) größer als B0 (linke Pfeile) und parallel oder antiparallel zu B0 ist, kann das zu messende Feld BM (mittlere Pfeile) entweder ebenfalls parallel zum Bias-Magnetfeld B0 orientiert und kleiner als B0 sein (oberes Diagramm in Figur 2), oder antiparallel zum Bias-Magnetfeld B0 orientiert und größer als B0 sein (unteres Diagramm in Figur 2).

Dem kann durch einen zeitlich veränderlichen Anteil im Bias-Magnetfeld begegnet werden, wobei sich das gesamte Bias-Magnetfeld B(t) nun aus einem konstanten Anteil B0 und einem zeitlich veränderlichen Anteil Bmod zusammensetzt:

$$B(t) = B0 + Bmod \sin(\omega t + \varphi)$$

da dann aus dem Vorzeichen der zeitlichen Änderung (Addition für parallel und Subtraktion für antiparallel) bzw. aus der Phase des gemessenen Signals BM+B(t) in Bezug auf die Phase $\varphi$ der erzeugten Modulation die Orientierung eindeutig bestimmt werden kann, wie in Figur 3 gezeigt, in der das gemessene Signal BM+B(t) gegen die Zeit aufgetragen ist.

301 bezeichnet den Messverlauf ohne Modulation, bei dem zwischen den beiden obengenannten Fällen nicht unterschieden werden kann. 302 und 303 bezeichnen die Messverläufe mit Modulation, die - in Abhängigkeit von der Richtung des resultierenden Feldes im Vergleich zum zeitlich veränderlichen Anteil - um 180° zueinander phasenverschoben sind. Ist das zu messende Feld kleiner als B0 und parallel, entspricht die Phase des gemessenen Feldes der der Modulation. Ist das zu messende Feld größer als B0 und antiparallel, ist die Phase des gemessenen Feldes zu der Phase der Modulation um 180° verschoben.

Die Bias-Magnetfeldanteile können beispielsweise durch entsprechende Ströme in einer Spulenanordnung erzeugt werden. Entsprechend ist ein Strom zur Erzeugung dieses Bias-Magnetfeldes beispielsweise wie folgt zusammengesetzt:

$$I(t) = I0 + Imod \sin(\omega t + \varphi)$$

Die Amplitude des langsam variierenden Magnetfeldanteils kann vergleichsweise klein sein, beispielsweise nur einem kleinen Anteil des statischen Magnetfeldes entsprechend, und die Frequenz kann z.B. in einem Bereich von 10 Hz bis 10 kHz liegen.

Anstatt eines statischen Stroms I0, der mittels einer Spule die statische Magnetfeldkomponente B0 erzeugt, kann die statische Magnetfeldkomponente B0 auch zumindest teilweise durch eine Anordnung von Permanentmagneten erzeugt werden.

Mit der hier vorgestellten Idee kann also sicher erkannt werden, ob das zu messende Magnetfeld ggf. eine gewisse Amplitude überschritten hat und in eine andere Richtung zeigt. Es kann also auch zu einer eindeutigen Plausibilisierung dienen. Dies kann insbesondere bei sicherheitsrelevanten Anwendungen des Magnetfeldsensors, z.B. in der Automobilindustrie, eine zwingende Voraussetzung sein.

## Patentansprüche

1. Magnetometereinheit zur Messung eines Magnetfelds, aufweisend:

ein Sensormedium (110), das einen Diamantkristall oder einen Abschnitt eines Diamantkristalls mit Stickstoff-Fehlstellen-Zentren aufweist und das dem zu messenden Magnetfeld ausgesetzt ist,
eine Anregungslichtquelle (120) zum Einstrahlen von Licht (124) in das Sensormedium (110),
eine Mikrowellenquelle (150) zum Erzeugen eines elektromagnetischen Felds in dem Sensormedium (110),
eine Einrichtung (140) zum Erzeugen eines Bias-Magnetfelds im Bereich des Sensormediums (110),
wobei die Magnetometereinheit dazu eingerichtet ist, eine magnetische Feldstärke und Feldrichtung des zu messenden Magnetfelds durch Auslesen von Spinresonanzen in dem Sensormedium (110) zu erfassen, die von der magnetischen Feldstärke und Feldrichtung abhängig sind,
wobei die Einrichtung (140) zum Erzeugen eines Bias-Magnetfelds dazu eingerichtet ist, ein Bias-Magnetfeld mit einem konstanten und einem zeitlich veränderlichen Anteil zu erzeugen, **dadurch gekennzeichnet, dass** die Magnetometereinheit dazu eingerichtet ist, zur Unterscheidung zwischen einem zu messenden Magnetfeld parallel zu dem Bias-Magnetfeld und einem zu messenden Magnetfeld antiparallel zu dem Bias-Magnetfeld aus einer Phase eines Signals, das auf das zu messende Magnetfeld zurückgeht, in Bezug auf eine Phase des zeitlich veränderlichen Anteils des Bias-Magnetfelds die Orientierung des zu messenden Magnetfelds eindeutig zu bestimmen.

2. Magnetometereinheit nach Anspruch 1, wobei eine Amplitude des zeitlich veränderlichen Anteils weniger als 50%, insbesondere höchstens 10% oder höchstens 20% oder höchstens 30%, einer Amplitude des konstanten Anteils beträgt.

3. Magnetometereinheit nach Anspruch 1 oder 2, wobei der zeitlich veränderliche Anteil einer periodischen Funktion, insbesondere Sinusfunktion folgt.

4. Magnetometereinheit nach Anspruch 3, wobei eine Grundfrequenz des zeitlich veränderlichen Anteils mindestens 10 Hz und/oder höchstens 10 kHz beträgt.

5. Gradiometereinheit aufweisend wenigstens zwei Magnetometereinheiten nach einem der vorhergehenden Ansprüche und eine Signalverarbeitungseinheit (170), die dazu eingerichtet ist, einen Magnetfeldgradienten aus den von den wenigstens zwei Magnetometereinheiten erfassten magnetischen Feldstärken und Feldrichtungen des zu messenden Magnetfelds zu ermitteln.

6. Gradiometereinheit nach Anspruch 5, wobei das Sensormedium (110) der wenigstens zwei Magnetometereinheiten jeweils einen Abschnitt desselben Diamantkristalls aufweist.

7. Gradiometereinheit nach Anspruch 5 oder 6, wobei die wenigstens zwei Magnetometereinheiten dieselbe Anregungslichtquelle (120) und/oder dieselbe Mikrowellenquelle (150) aufweisen.

**Claims**

1. Magnetometer unit for measuring a magnetic field, comprising:

    a sensor medium (110) comprising a diamond crystal or a section of a diamond crystal with nitrogen-vacancy centres, the sensor medium being exposed to the magnetic field to be measured;

    an excitation light source (120) for radiating light (124) into the sensor medium (110),
    a microwave source (150) for generating an electromagnetic field in the sensor medium (110),
    a device (140) for generating a bias magnetic field in the region of the sensor medium (110),
    wherein the magnetometer unit is configured to detect a magnetic field strength and field direction of the magnetic field to be measured, by reading out spin resonances in the sensor medium (110) which are dependent on the magnetic field strength and field direction,
    wherein the device (140) for generating a bias magnetic field is configured to generate a bias magnetic field having a constant portion and a temporally variable portion, **characterized in that**
    the magnetometer unit is configured to unambiguously determine the orientation of the magnetic field to be measured, for the purpose of distinguishing between a magnetic field to be measured parallel to the bias magnetic field and a magnetic field to be measured antiparallel to the bias magnetic field, from a phase of a signal that is attributed to the magnetic field to be measured in relation to a phase of the temporally variable portion of the bias magnetic field.

2. Magnetometer unit according to Claim 1, wherein an amplitude of the temporally variable portion is less than 50%, in particular at most 10% or at most 20% or at most 30%, of an amplitude of the constant portion.

3. Magnetometer unit according to Claim 1 or 2, wherein the temporally variable portion follows a periodic function, in particular sine function.

4. Magnetometer unit according to Claim 3, wherein a fundamental frequency of the temporally variable portion is at least 10 Hz and/or at most 10 kHz.

5. Gradiometer unit comprising at least two magnetometer units according to any of the preceding claims and a signal processing unit (170), which is configured to ascertain a magnetic field gradient from the magnetic field strengths and field directions of the magnetic field to be measured that are detected by the at least two magnetometer units.

6. Gradiometer unit according to Claim 5, wherein the sensor medium (110) of the at least two magnetometer units comprises in each case a section of the same diamond crystal.

7. Gradiometer unit according to Claim 5 or 6, wherein the at least two magnetometer units comprise the same excitation light source (120) and/or the same microwave source (150).

**Revendications**

1. Unité de magnétomètre destinée à mesurer un champ magnétique, comportant :

   un milieu capteur (110), qui comporte un cristal de diamant ou une partie d'un cristal de diamant avec des centres lacune-azote et qui est exposé au champ magnétique à mesurer ;
   une source de lumière d'excitation (120) pour irradier de la lumière (124) dans le milieu capteur (110),
   une source de micro-ondes (150) destinée à générer un champ électromagnétique dans le milieu capteur (110),
   un dispositif (140) destiné à générer un champ magnétique de polarisation dans la région du milieu capteur (110),
   l'unité de magnétomètre étant conçue pour détecter une intensité et une direction du champ magnétique à mesurer par lecture de résonances de spin dans le milieu capteur (110), lesquelles dépendent de l'intensité et de la direction du champ magnétique,
   le dispositif (140) destiné à générer un champ magnétique de polarisation étant conçu pour générer un champ magnétique de polarisation avec une partie constante et une partie qui varie dans le temps, **caractérisée en ce que**
   l'unité de magnétomètre est conçue, afin de distinguer entre un champ magnétique à mesurer parallèle au champ magnétique de polarisation et un champ magnétique à mesurer antiparallèle au champ magnétique de polarisation, pour déterminer de manière univoque l'orientation du champ magnétique à mesurer à partir d'une phase d'un signal, qui provient du champ magnétique à mesurer, par rapport à une phase de la partie qui varie dans le temps du champ magnétique de polarisation.

2. Unité de magnétomètre selon la revendication 1, dans laquelle une amplitude de la partie qui varie dans le temps est inférieure à 50 %, en particulier d'au plus 10 % ou d'au plus 20 % ou d'au plus 30 %, d'une amplitude de la partie constante.

3. Unité de magnétomètre selon la revendication 1 ou 2, dans laquelle la partie qui varie dans le temps suit une fonction périodique, en particulier une fonction sinusoïdale.

4. Unité de magnétomètre selon la revendication 3, dans laquelle une fréquence fondamentale de la partie qui varie dans le temps est d'au moins 10 Hz et/ou d'au plus 10 kHz.

5. Unité de gradiomètre comportant au moins deux unités de magnétomètre selon l'une quelconque des revendications précédentes et une unité de traitement de signal (170), laquelle est conçue pour déterminer un gradient de champ magnétique à partir des intensités et des directions du champ magnétique à mesurer, détectées par les au moins deux unités de magnétomètre.

6. Unité de gradiomètre selon la revendication 5, dans laquelle le milieu capteur (110) des au moins deux unités de magnétomètre comporte respectivement une partie du même cristal de diamant.

7. Unité de gradiomètre selon la revendication 5 ou 6, dans laquelle les au moins deux unités de magnétomètre comportent la même source de lumière d'excitation (120) et/ou la même source de micro-ondes (150).

Fig. 1

# Fig. 2

B0    BM    B0+BM

# Fig. 3

## IN DER BESCHREIBUNG AUFGEFÜHRTE DOKUMENTE

**In der Beschreibung aufgeführte Patentdokumente**

- DE 102022204526

- DE 102022201690

**In der Beschreibung aufgeführte Nicht-Patentliteratur**

- **V. M. ACOSTA et al.** Broadband magnetometry by infraredabsorption detection of nitrogen-vacancy ensembles in diamond. *Appl. Phys. Lett.*, 2010, vol. 97, 174104